# EUROPEAN PATENT APPLICATION

(11) **EP 4 734 302 A1**
(43) Date of publication of application: **29.04.2026**
(21) Application number: 25211484.8
(22) Date of filing: 27.10.2025
(51) Int. Cl.: H02G 1/08, G01R 33/02, G01B 3/10

(54) **METRIC CABLE PULLER PROBE WITH MAGNETIC TIP**

(30) Priority: 28.10.2024 IT 202400024018
(71) Applicant: C.S.A. Impianti S.n.c. di Camusso Simone Giuseppe Giuseppe & C., 10040 Cumiana (Torino) (IT)
(72) Inventor: CALOGERO, Salvatore Andrea, I-10040 CUMIANA (Torino) (IT)
(74) Representative: Aseglio-Gianinet, Romina

(57) **Abstract**

The present invention relates to an apparatus for identifying interruptions in corrugated pipes, preferably in PVC, and in recessed junction boxes concealed under layers of construction work, comprising: a cable puller probe, preferably metric, a detection system configured to receive and interpret the signal emitted by the magnetic tip of the probe and visualize its exact position; wherein the functional combination of the probe, the magnetic tip, and the detection system allows for the prompt and precise identification of the position of any interruptions in the corrugated pipes and in the recessed junction boxes.

## Description

### Field of the Invention

The present invention relates to the field of tools for electrical installations, and in particular to devices intended for identifying interruptions in corrugated pipes (conduits) and for the precise localization of recessed junction boxes that have become concealed under layers of construction work.

### State of the Art (Background)

The field of electrical installations and related technologies for localizing hidden infrastructures, such as PVC piping and recessed junction boxes, requires devices capable of ensuring precise and reliable measurements. Operators, involved in the construction and maintenance of such systems, must be able to rely on tools that allow them not only to determine the path of the conduits but also to effectively identify critical points along the building structures. The complexity of modern installations, characterized by multiple coatings and finishes, highlights the need for technical solutions capable of overcoming the limitations of traditional approaches, favouring accurate monitoring of hidden paths within the masonry.

The applications in this sector involve specific functional objectives, such as localizing any anomalies along the paths of the pipes and recessed boxes. To guarantee correct execution of the work, it is essential to have tools that ensure timely detection of variations in the path, thereby facilitating the process of installation, maintenance, and restoration of broken pipes under cementitious or similar layers. The importance of these applications lies in the fact that, in the presence of complex configurations, any imprecision can lead to prolonged intervention times and higher operating costs, making the refinement of monitoring techniques indispensable.

Despite the widespread use of detection and measurement systems, difficulties persist regarding the precise identification of discontinuities present inside the piping or recessed boxes. Conventional techniques, while providing useful information on the route, do not always manage to accurately pinpoint any interruptions or geometric anomalies, especially in the presence of complex building structures or protective layers. This operational gap can necessitate corrective actions that, if not addressed with due precision, lead to considerable impacts not only in terms of costs but also in terms of timeframes and quality of the installation service.

In particularly sensitive operating environments, localizing breakages or anomalies within conduits and recessed elements that have become concealed under layers of construction work becomes a significant challenge. The presence of substantial coverings, such as plaster and cementitious layers, hinders direct access to critical points, making it indispensable to adopt methodologies that allow the exact site of the anomaly to be determined non-invasively. The traditional approach, which sometimes involves removing part of the protective coating, can cause aesthetic and structural damage, as well as delay restoration operations. Therefore, there is a marked need to develop a system that incorporates sophisticated localization techniques, capable of optimizing interventions and minimizing impact on the operating context.

Furthermore, a cable is an electrical component consisting of a bundle of multiple conductive wires or optical fibers coated with a layer of insulating material, whose function is to transmit electric current or light for the transport of electrical energy (only in the case of cables equipped with electrical wires) or for the exchange of information. A cable can be composed of a single core (single-pole) or multiple cores enclosed in a protective sheath (multi-pole).

The laying of a cable, that is, the act of installing a cable within an electrical system, can be carried out in three different ways, on which the type of cable depends:
∘ aerial cable;
∘ cable inside pipes, ducts, channels, and trays;
∘ buried cable.

For cables whose laying must be carried out using pipes, ducts, channels, and trays, this is referred to as laying the cable inside pipes, ducts, channels, and trays.

During the laying of the cable inside pipes, ducts, channels, and trays, one of the laying phases is pulling.

Pulling is the laying phase that involves passing the electrical conductor (electrical cable or copper wire, mostly) inside pipes, ducts, channels, and trays. During this phase, attention must be paid to various variables:
- the direction of the applied thrust and for how long it occurs;
- the weight of the cable;
- how much friction is present between the cable and the pipe;
- the number of bends in the pipe into which the cable is inserted and their circumference;
- the type of cable inserted into the pipe and their arrangement;
- the temperature of the surrounding environment, especially when it is low.

Pulling is therefore a delicate and fundamental phase of cable laying, and it is essential to plan it carefully using the correct formulas and friction constants for calculation. Furthermore, during the pulling phase of an electrical conductor (cable or copper wire, mostly) inside the appropriate pipes or ducts, it is often necessary to be aware of the length of the pipes/ducts in order to minimize waste of the electrical conductor. In order to know this length, the operator in charge of the pulling is often forced to use and feed a cable puller probe (or fish tape) into the pipe, before pulling the electrical conductor. A cable puller probe is an essential tool for installing electrical conductors in pipes and conduits. It can be a metallic cable or a thin tube made of polymer material or a long braid of metallic or polymeric wires. Its main characteristic is that it is more or less flexible, depending on the material it is made of. Precisely because of its flexibility, it helps to pass the cables into the pipes quite easily. Its operation is relatively simple: the probe is inserted into the pipe from the starting electrical box and made to slide until it reaches the other end. The probe is equipped with a specific eyelet inside which the conductors, grouped and folded back, are inserted. However, when the operator in charge of the pulling is unaware of the length of the pipes/ducts into which they must feed the electrical conductors, they must, as mentioned above, use and feed the cable puller probe before pulling the electrical conductor. Specifically: the operator feeds one end of the cable puller probe into the (for example) pipe and slides it along the entire length of the pipe. Once the end of the pipe length is reached, they apply a visual mark (e.g., with a marker or a piece of tape) on the probe corresponding to the end of the pipe length. They then pull the cable puller probe out of the pipe and measure the distance between the aforementioned end of the cable puller probe and the visual mark; this measurement corresponds to the length of the pipe. Once the operator has thus become aware of the length of the pipe, they cut the electrical conductor to size according to the measurement data obtained.

It is clear from this that this operation is complex, long, laborious, and imprecise.

Therefore, there is a marked need to develop a system that incorporates sophisticated localization techniques, capable of optimizing interventions and minimizing impact on the operating context. Furthermore, the possibility of having a cable puller probe that allows the length of the pipes to be measured easily, quickly, and precisely is therefore a strongly felt market need.

### Summary of the Invention

The objective of the present invention is therefore to develop a system that incorporates sophisticated localization techniques, capable of optimizing interventions and minimizing impact on the operating context.

This objective is achieved by an apparatus for identifying interruptions in corrugated pipes and in recessed junction boxes concealed under layers of construction work, as outlined in the appended claims, the definitions of which form an integral part of this description.

### Brief Description of the Drawings

The invention will be better understood from the following detailed description of its preferred embodiments, given by way of example and therefore not limiting, with reference to the attached figures, where:
- Figure 1 shows a perspective view of an embodiment of the apparatus according to the present invention.
- Figure 1A shows a front view of a prior art cable puller probe;
- Figure 1B shows a front view of an embodiment of a metric cable puller probe according to the present invention;
- Figure 2A shows a front view of another prior art cable puller probe;
- Figure 2B shows a front view of another embodiment of a metric cable puller probe according to the present invention.

In the attached Figures, equal or similar elements will be indicated by the same numerical references.

### Detailed Description of the Invention

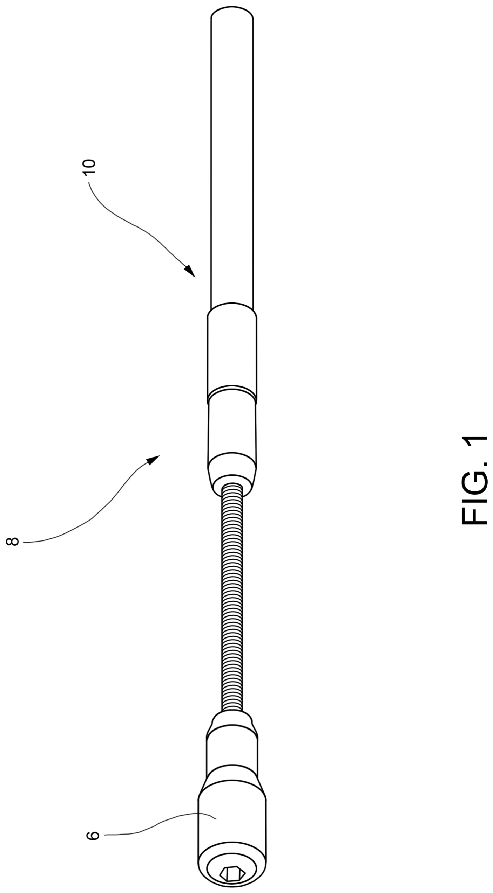

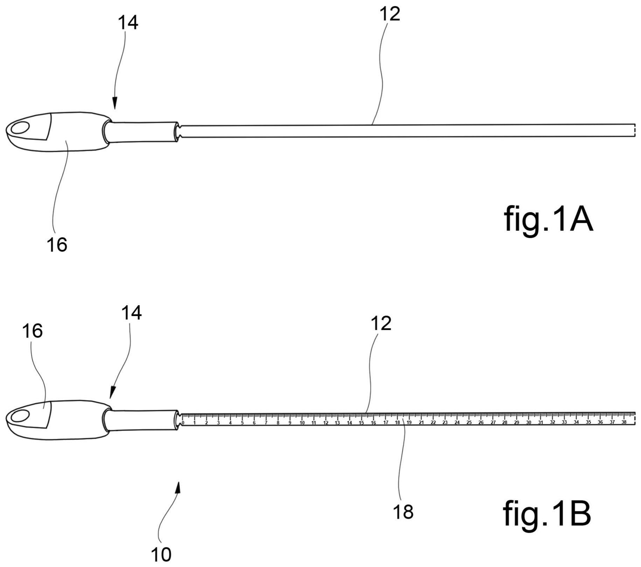

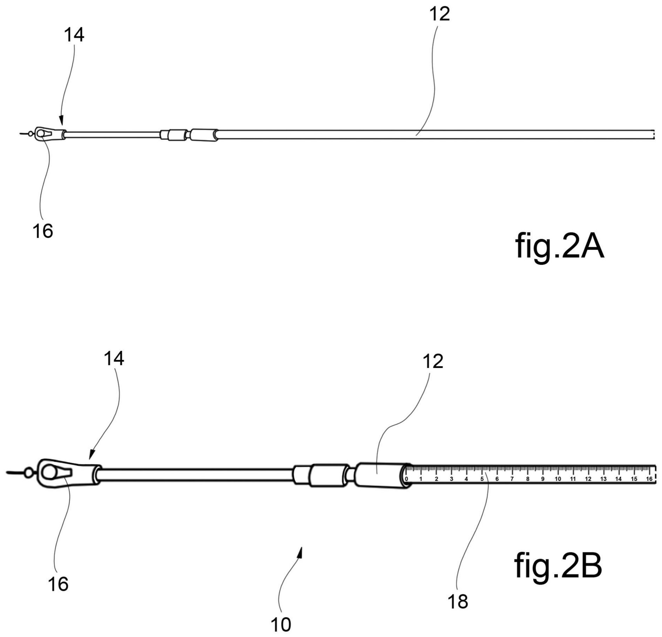

With reference to Figures 1, 1B and 2B, a first object of the present invention is shown, namely an apparatus (8) for identifying interruptions in corrugated pipes, preferably in PVC, and in recessed junction boxes concealed under layers of construction work, comprising:
a probe, preferably a cable puller probe 10, configured to be introduced inside a corrugated pipe or a recessed junction box;
a magnetic tip 6 intended to replace the conventional terminal part of the probe 10, which is made of a magnetic material, preferably selectable from neodymium or similar materials, capable of generating a detectable magnetic field;
a detection system using a smartphone, which comprises a mobile application equipped with a module for measuring magnetic field intensity, configured to:
   receive and interpret the signal emitted by the magnetic tip 6 and visualize its exact position and wherein the functional combination of the probe 10, the magnetic tip 6, and the detection system allows for the prompt and precise identification of the position of any interruptions in the corrugated pipes and in the recessed junction boxes concealed under layers of construction work.

According to a preferred embodiment of the apparatus 8 according to the present invention, the magnetic tip 6 is preferably made entirely of neodymium.

According to a preferred embodiment of the apparatus 8 according to the present invention, the module for measuring the magnetic field intensity is preferably calibrated to detect minimum variations in the field, allowing the precise localization of the magnetic tip (6) even in the presence of cementitious layers, such as even through cementitious layers of a thickness exceeding 20 cm.

According to a preferred embodiment of the apparatus 8 according to the present invention, the mobile application is preferably further configured to calculate data related to the position and intensity of the magnetic field.

According to a preferred embodiment of the apparatus 8 according to the present invention, the probe 10 is preferably equipped with an ergonomic support that ensures stable and secure positioning inside the corrugated pipe or the recessed junction box.

According to a preferred embodiment of the apparatus 8 according to the present invention, the magnetic tip 6 is preferably designed to be removable from the terminal part of the probe 10 and allow easy replacement or maintenance.

According to a preferred embodiment of the apparatus 8 according to the present invention, the detection system using a smartphone preferably allows the path of the magnet to be tracked.

According to a preferred embodiment of the apparatus 8 according to the present invention, the probe 10, the magnetic tip 6, and the detection system are preferably integrated into a modular device, optimized for prompt and precise identification of interruptions in PVC corrugated pipes and in recessed junction boxes and for minimizing the invasiveness of restoration operations.

As known to the skilled person, the sector of electrical installations and the localization of hidden infrastructures, such as PVC corrugated pipes and recessed junction boxes, presents significant challenges related to the precise identification of interruptions or anomalies. Conventional techniques, while providing useful information on the route of the conduits, are often inadequate for accurately locating critical points, especially in the presence of complex building structures or protective layers such as plaster and cementitious coatings. Such limitations lead to invasive interventions, such as the demolition of floors or walls, resulting in high costs, prolonged times, and potential aesthetic and structural damage. Furthermore, the difficulty of identifying recessed junction boxes concealed under layers of work, such as tiles or plaster, further exacerbates the problem, making the development of more precise and less invasive solutions indispensable.

The proposed invention overcomes these limitations by introducing an innovative device that combines a probe with a magnetic tip made of magnetic material, such as neodymium, and a smartphone-based detection system. The magnetic tip generates a detectable magnetic field through cementitious layers even exceeding 20 cm in thickness, allowing for precise and non-invasive localization of interruptions in the corrugated pipes or the recessed junction boxes. The detection system, via a mobile application equipped with a module for measuring magnetic field intensity, interprets the signal emitted by the magnetic tip and visualizes its exact position. This solution not only eliminates the need for destructive interventions but also optimizes operational times and costs, significantly improving the efficiency of installation and maintenance operations.

The technical approach adopted integrates further functionalities, such as the ability of the detection system to track the magnet's path. Furthermore, the device is designed in a modular form, with ergonomic and removable components, ensuring ease of use, maintenance, and replacement. Thanks to these features, the invention represents a significant advance over traditional approaches, offering a complete, precise, and non-invasive solution for localizing interruptions and anomalies in complex building contexts.

Advantageously, moreover, the magnetic tip made of magnetic material, such as neodymium, generates a detectable magnetic field through cementitious layers even exceeding 20 cm in thickness. This configuration allows the position of the tip to be precisely localized, even in the presence of physical obstacles, eliminating the need to remove protective coatings or perform demolitions. The ability to detect minimum variations in the magnetic field advantageously guarantees accurate localization even in complex building contexts.

Advantageously, furthermore, the integration of a detection system using a smartphone, equipped with a mobile application for measuring magnetic field intensity, allows the signal emitted by the magnetic tip to be received and interpreted and its exact position to be visualized. This approach leverages existing smartphone technology to provide an economical and accessible solution, reducing the need for dedicated devices.

Advantageously, moreover, the modular design of the device allows the probe, the magnetic tip, and the detection system to be integrated into a single tool, optimizing portability and ease of use. Modularity also facilitates the maintenance and replacement of components, reducing downtime and operating costs.

Advantageously, furthermore, the removable magnetic tip offers a practical advantage, allowing easy replacement or maintenance without compromising the integrity of the probe. This feature increases the overall lifespan of the device and improves its operational sustainability.

Finally, advantageously, the ergonomic support of the probe ensures stable and secure positioning inside the corrugated pipe or the recessed junction box, improving the precision of the measurements and reducing operator fatigue during prolonged use.

Preferably, moreover, the cable puller probe 10 according to the present invention comprises a main body 12 substantially cylindrical or trapezoidal or squared, whose length dimension is greater than that of the width and thickness, wherein said main body 12 comprises a first end 14 opposite a second end (not shown in Figures 1, 1A, 1B, 2A, and 2B), wherein at both said first end 14 and said second end, there is an eyelet 16 or a flexible metallic tip with relative accessories, characterized in that a plurality of measurement markings 18 are preferably present on the main body 12.

Preferably, said main body 12 has a length comprised between 1 m and 500 m, a width comprised between 1 mm and 40 mm, and a thickness comprised between 1 mm and 40 mm.

Preferably, the two eyelets (or flexible metallic tips with relative accessories) 16 are made of metallic material.

According to an alternative embodiment of the cable puller probe 10, preferably metric, according to the present invention, the main body 12 is optionally covered by a metallic or polymeric sheath on which the measurement markings 18 are drawn or engraved or marked.

According to a preferred embodiment of the cable puller probe 10, preferably metric, according to the present invention, each measurement marking 18 is preferably distanced from the subsequent, and/or from the preceding, by a value equal to: 1 mm, 1dm, 1cm, 1m, 1 inch, 1 foot or 1 yard. Even more preferably, each measurement marking 18 is distanced from the subsequent, and/or from the preceding, by a value equal to: 1 mm.

According to a preferred embodiment of the cable puller probe 10, preferably metric, according to the present invention, the main body 12 is preferably: a cable, a braid of wires, a hollow or solid tube. Even more preferably, the main body 12 is flexible. Preferably, the main body 12 is made of metallic material or polymeric material.

According to a preferred embodiment of the cable puller probe 10, preferably metric, according to the present invention, the measurement markings 18 are preferably drawn or engraved or marked on the main body.

A further object of the present invention relates to a process for the production of a cable puller probe 10, preferably metric, as described above, comprising the steps of:
a) providing a cable puller probe comprising a main body 12 substantially cylindrical or trapezoidal or squared, whose length dimension is greater than that of the width and thickness, wherein said main body 12 comprises a first end 14 opposite a second end, wherein at both said first end 14 and said second end, there is an eyelet 16 or a flexible metallic tip with relative accessories;
b) preferably drawing or engraving or marking a plurality of measurement markings 18 on the main body 12 of the cable puller probe from step a);
thereby obtaining the cable puller probe 10, preferably metric, according to the present invention.

Preferably, step b) of engraving is carried out using a laser or a lathe or an engraver or any other instrument capable of engraving the main body 12 of the cable puller probe 10, preferably metric, according to the present invention.

Preferably, step b) of drawing is carried out using a marker or a pencil or a paint or any other instrument capable of drawing on the main body 12 of the cable puller probe 10, preferably metric, according to the present invention.

Preferably, step b) of marking is carried out using optical markers such as adhesives or stickers or other material that can create a marker (a sign) on the main body 12 of the cable puller probe 10, preferably metric, according to the present invention.

According to a preferred embodiment of the process according to the present invention, the plurality of measurement markings 18 are, preferably, drawn or engraved or marked so that each measurement marking 18 is distanced from the subsequent, and/or from the preceding, by a value equal to: 1 mm, 1 dm, 1 cm, 1 m, 1 inch, 1 foot or 1 yard. Even more preferably, the plurality of measurement markings 18 are drawn or engraved or marked so that each measurement marking 18 is distanced from the subsequent, and/or from the preceding, by a value equal to 1 mm.

The process according to the present invention therefore advantageously involves drawing or engraving or marking cable puller probes currently on the market in order to obtain the cable puller probe 10, preferably metric, according to the present invention. Advantageously, with the process according to the present invention, it is therefore possible to draw or engrave or mark already existing cable puller probes, of all sizes and for all uses, for small, medium, and large construction sites, even at street level.

A further object of the present invention relates to the use of the cable puller probe 10, preferably metric, as described above for measuring the length of pipes, ducts, channels, or trays for pulling electrical conductors. Preferably, said electrical conductors are electrical cables or copper wires.

Advantageously, the cable puller probe 10, preferably metric, according to the present invention can be used in all sectors where it is necessary to lay an electrical conductor, regardless of the size and type of the electrical conductor, the size and type of pipes, ducts, channels or trays, and the size and type of cable puller probe currently on the market.

Advantageously, therefore, the cable puller probe 10, preferably metric, according to the present invention allows the length of the pipes to be measured easily, quickly, and precisely.

## Claims

1. Apparatus (8) for identifying interruptions in corrugated pipes, preferably in PVC, and in recessed junction boxes concealed under layers of construction work, comprising:
- a cable puller probe, preferably metric, (10) comprising a main body (12) substantially cylindrical or trapezoidal or squared, whose length dimension is greater than that of the width and thickness, wherein said main body (12) comprises a first end (14) opposite a second end, wherein at both said first end (14) and said second end, there is an eyelet (16) or a flexible metallic tip with relative accessories, wherein a plurality of measurement markings (18) are preferably present on the main body (12) and wherein said probe (10) is configured to be introduced inside a corrugated pipe or a recessed junction box; wherein at said first end or said second end there is a magnetic tip (6) intended to replace the first and/or the second end, which is made of a magnetic material, preferably selectable from neodymium or similar materials, capable of generating a detectable magnetic field;
- a detection system using a smartphone, which includes a mobile application equipped with a module for measuring magnetic field intensity, configured to:
receive and interpret the signal emitted by the magnetic tip (6) and visualize its exact position;
wherein the functional combination of the probe (10), the magnetic tip (6), and the detection system allows for the prompt and precise identification of the position of any interruptions in the corrugated pipes and in the recessed junction boxes.

2. Apparatus (8) according to claim 1, wherein the magnetic tip (6) is made entirely of neodymium.

3. Apparatus (8) according to any one of claims 1 to 2, wherein the module for measuring the magnetic field intensity is calibrated to detect minimum variations in the field, allowing the precise localization of the magnetic tip (6) even in the presence of cementitious layers.

4. Apparatus (8) according to any one of claims 1 to 3, wherein the mobile application is further configured to calculate data related to the position and intensity of the magnetic field.

5. Apparatus (8) according to any one of claims 1 to 4, wherein the probe is equipped with an ergonomic support that ensures: stable positioning and secure positioning inside the corrugated pipe or the recessed junction box.

6. Apparatus (8) according to any one of claims 1 to 5, wherein the magnetic tip (6) is designed to be: removable from the terminal part of the probe (10) and allow easy replacement or maintenance.

7. Apparatus (8) according to any one of claims 1 to 6, wherein the detection system using a smartphone allows the path of the magnet to be tracked.

8. Apparatus (8) according to any one of claims 1 to 7, wherein: the probe (10), the magnetic tip (6), and the detection system are integrated into a modular device, optimized for: promptly and precisely identifying interruptions in corrugated pipes, preferably in PVC, and in recessed junction boxes concealed under layers of construction work and minimizing the invasiveness of restoration operations.

9. Cable puller probe (10) according to any one of claims 1 to 8, wherein each measurement marking (18) is distanced from the subsequent, and/or from the preceding, by a value equal to: 1 mm, 1 dm, 1 cm, 1 m, 1 inch, 1 foot or 1 yard.

10. Cable puller probe (10) according to any one of claims 1 to 9, wherein the main body (12) is: a cable, a braid of wires, a hollow or solid tube.

11. Cable puller probe (10) according to any one of claims 1 to 10, wherein the measurement markings (18) are drawn or engraved or marked on the main body (12).

12. Process for the production of a cable puller probe (10), preferably metric, according to any one of claims 1 to 11, comprising the steps of:
a) providing a cable puller probe comprising a main body (12) substantially cylindrical or trapezoidal or squared, whose length dimension is greater than that of the width and thickness, wherein said main body (12) comprises a first end (14) opposite a second end, wherein at both said first end (14) and said second end, there is an eyelet (16) or a flexible metallic tip with relative accessories;
b) preferably drawing or engraving or marking a plurality of measurement markings (18) on the main body (12) of the cable puller probe from step a);
thereby obtaining a cable puller probe (10), preferably metric, according to any one of claims 1 to 11.

13. Process according to claim 12, wherein the plurality of measurement markings (18) are drawn or engraved or marked so that each measurement marking (18) is distanced from the subsequent, and/or from the preceding, by a value equal to: 1 mm, 1 dm, 1 cm, 1 m, 1 inch, 1 foot or 1 yard.

14. Use of the cable puller probe (10), preferably metric, according to any one of claims 1 to 11 for measuring the length of pipes, ducts, channels, or trays for pulling electrical conductors.
